# EUROPÄISCHE PATENTSCHRIFT

(11) **EP 1 921 456 B1**
(45) Veröffentlichungstag und Bekanntmachung des Hinweises auf die Patenterteilung: **25.09.2013**
(21) Anmeldenummer: 07120174.3
(22) Anmeldetag: 07.11.2007
(51) Int. Cl.: G01R 1/20, G01R 19/00, G01R 31/36

(54) **Kraftfahrzeugsensor, insbesondere Batteriesensor, mit Messwiderstand**
Motor vehicle sensor, in particular battery sensor, with measuring resistance
Capteur de véhicule automobile, en particulier capteur de batterie, doté d'une résistance de mesure

(30) Priorität: 10.11.2006 DE 102006053021
(43) Veröffentlichungstag der Anmeldung: 14.05.2008
(73) Patentinhaber: Hella KGaA Hueck & Co., 59552 Lippstadt (DE)
(72) Erfinder: Lütkenhaus, Kai, 59227, Paderborn (DE); Schöllmann, Matthias, 33100, Paderborn (DE); Unterhalt, Marco, 33154, Salzkotten (DE)

(56) Entgegenhaltungen:
- EP-A1- 1 278 069
- WO-A1-01/75431
- WO-A1-2006/034897
- DE-A1- 10 031 243
- DE-A1-102004 053 647
- DE-A1-102004 053 648
- DE-A1-102004 055 849
- DE-B3- 10 332 410
- DE-B3- 10 336 107
- DE-C1- 10 001 345
- US-B1- 6 351 115

## Beschreibung

Die Erfindung betrifft einen Kraftfahrzeugsensor, insbesondere einen Batteriesensor, mit einem Messwiderstand umfassend ein Widerstandselement und einer Schaltungsanordnung zum Ermitteln, Auswerten und/oder Bearbeiten von Messgrößen.

Für die Messung von Strömen und anderen elektrischen Größen werden häufig Nebenwiderstände, auch Shunts genannt, verwendet. Aus der Druckschrift mit der Veröffentlichungsnummer EP 1 278 069 A1 sind verschiedene Bauformen von Nebenwiderständen bekannt.

Aus den Druckschriften mit den Veröffentlichungsnummern DE 103 32 410 B3, DE 10 2004 055 849 A1 und DE 10 2004 037 194 A1 sind derartige Batteriesensoren bekannt. Konstruktionsbedingt sind diese Sensoren auf bestimmte Einbauorte und bestimmte mechanische oder elektrische Verbindungen mit den Autobatterien festgelegt. Besonders häufig werden derartige Batteriesensoren in der so genannten Polnische an der Starterbatterie angeordnet. Dadurch ergeben sich bestimmte Anforderungen an die geometrische Ausgestaltung des Batteriesensors und infolgedessen auch des Widerstandelements des Messwiderstands. Ferner weisen die Nebenwiderstände neben dem Widerstandselement auch Anschlusselemente auf, über welche die Widerstandselemente elektrisch mit der Batterie bzw. einem Massekabel verbunden werden können. Auch wegen der Notwendigkeit dieser Anschlusselemente ist man bisher beim Gestalten der Batteriesensoren stark eingeschränkt.

Andererseits ist es denkbar, dass in Zukunft Batteriesensoren oder ähnlich ausgestaltete Kraftfahrzeugsensoren mit Nebenwiderständen an anderen Orten als der Polnische angebracht werden. Denkbar ist beispielsweise eine Befestigung eines Sensors am Masseanschlussbolzen an einer Karosserie, im Massekabel oder in einem Steuergerät.

Der Wunsch, derartige Kraftfahrzeugsensoren und insbesondere die Batteriesensoren an anderen Orten als der Polnische anzubringen, führt dazu, das Gestaltungskonzept der Batteriesensoren grundsätzlich zu überdenken. Dieses ist der technologische Hintergrund für die vorliegende Erfindung.

Ein Batteriesensor, der flexibel eingesetzt werden kann, ist zum Beispiel aus der Druckschrift mit der Veröffentlichungsnummer DE 10 2004 053 648 A1 bekannt. Diese Druckschrift offenbart einen Batteriesensor mit einem Träger und einem Messwiderstand. Der Messwiderstand umfasst ein Widerstandselement und eine Schaltungsanordnung zum Ermitteln, Auswerten und/oder Bearbeiten von Messgrößen. Der Träger weist einen Ring auf, in welchen ein Ende des Widerstandselementes fest gefügt angeordnet ist. Ein diesem Ende gegenüberliegendes Ende ist über ein Anschlusselement mit einem Kabel elektrisch und mechanisch verbunden.

Die Schaltungsanordnung weist einen Schaltungsträger auf, der über elektrische und mechanische Verbindungsmittel mit Bereichen an den Enden des Widerstandselementes verbunden ist. Der Schaltungsträger ist nur mit dem Widerstandselement, nicht jedoch mit dem Träger verbunden.

Der vorliegenden Erfindung liegt das Problem zugrunde, einen Kraftfahrzeugsensor und insbesondere einen Batteriesensor vorzuschlagen, dessen Gestaltung an verschiedene Einsatzorte und Anschlussorte angepasst sein kann und möglichst kompakt und platzsparend gestaltet ist. Diese Aufgabe wird durch einen erfindungsgemäßen Sensor nach Anspruch 1 gelöst. Vorteilhafte Weiterbildungen der Erfindung sind in den Ansprüchen 2 bis 11 angegeben.

Das Widerstandselement eines erfindungsgemäßen Sensors ist zylindrisch und hat eine Stirnseite die unmittelbar mit dem elektrischen Leiter eines Kabelsverbunden ist. Das Widerstandselement ist unmittelbar an dem Kabel mechanisch und/oder elektrisch angeschlossen. Deshalb können Kontaktelemente, wie sie aus dem Stand der Technik zum Verbinden des Widerstandselements mit Kabeln notwendig bekannt sind, bei einer derartigen Ausgestaltung des Widerstandelements des Messwiderstands entfallen, wodurch sich mehr Spielraum für die Gestaltung des Batteriesensors ergibt.

Es ist möglich, dass der Messwiderstand und insbesondere das Widerstandselement des Messwiderstands einen offenen oder geschlossenen Hohlraum einschließt. Ein derartiger Hohlraum oder mehrere derartiger Hohlräume können dazu geeignet sein, um Kotaktierungen des Messwiderstands zu ermöglichen. Außerdem kann die Gestaltung des Messwiderstands bzw. des Widerstandelements des Messwiderstands mit Hohlräumen vorteilhaft für bestimmte Anbringungsorte des Sensors sein.

Bei einem erfindungsgemäßen Sensor könnte beispielsweise ein Leiter des Kabels in den offenen Hohlraum des Widerstandelements eingeführt und in dem offenen Hohlraum elektrisch und mechanisch mit dem Widerstandselement verbunden sein.

Der Leiter des Kabels kann mit dem Widerstandselement, insbesondere in dem Fall in denen der Leiter in den offenen Hohlraum eingeführt ist, durch Crimpen, Klemmen, Löten, Kleben, Schweißen, insbesondere Orbital- oder Reibschweißen, durch Prägen, Nieten oder anderen Fügeverfahren verbunden sein.

Die Schaltungsanordnung zum Ermitteln, Auswerten und/oder Bearbeiten von Messgrößen kann unmittelbar oder unter Zwischenschaltung von Kontaktelementen mit dem Widerstandselement elektrisch und/oder mechanisch verbunden sein. Zum Fügen der Schaltungsanordnung mit dem Widerstandselement bzw. dem Kontaktelement mit dem Widerstandselement kann eines der vorgenannten Verfahren gewählt werden.

Ein erfindungsgemäßer Sensor kann einen Träger aufweisen, an welchem die Schaltungsanordnung angebracht ist oder in welchem die Schaltungsanordnung integriert, z. B. eingespritzt oder eingelegt ist. An dem Träger kann eine Buchse oder ein Stecker für eine Datenverbindung vorgesehen sein. Ebenso kann der Träger ein Gehäuse umfassen oder mit einem Gehäuse verbunden sein, in welchem die Schaltungsanordnung eingehaust ist.

Als Kontaktelemente können Federn vorgesehen sein.

Ein Ausführungsbeispiel für einen erfindungsgemäßen Batteriesensor mit einem Messwiderstand und einer Schaltungsanordnung zum Auswerten und/oder Bearbeiten von Messgrößen ist anhand der Zeichnung näher erläutert. Dabei zeigt:
Fig. 1 eine Ansicht des Batteriesensors von vorn und
Fig. 2 eine Draufsicht des Batteriesensors

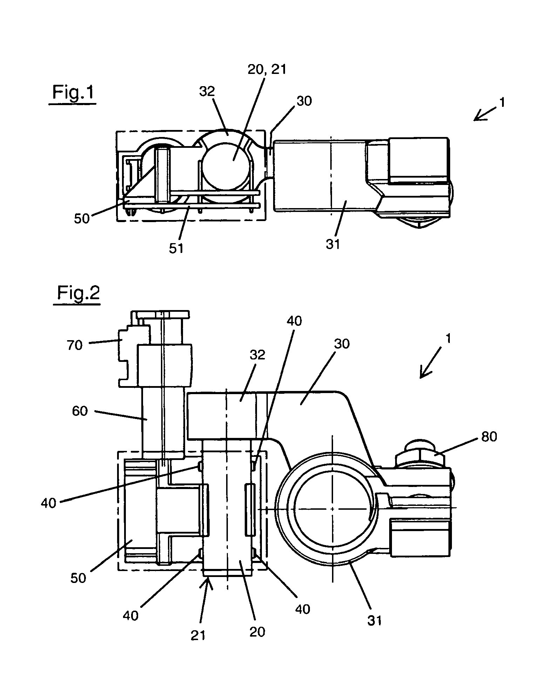

Der in den Fig. 1 und Fig. 2 dargestellte erfindungsgemäße Batteriesensor 1 weist einen Messwiderstand 20 auf, der mit einem Pol, vorzugsweise dem Minuspol einer Batterie und einem Masseanschluss der Karosserie elektrisch angeschlossen werden kann.

Der Messwiderstand 20 ist zylindrisch ausgebildet und aus einer CuMnNi-Legierung hergestellt. Der Messwiderstand umfasst ein Widerstandselement; Anschlusselemente sind nicht vorgesehen.

Zur Verbindung mit einem Massekabel ist die Stirnseite 21 des zylindrischen Widerstandelements unmittelbar durch eine geeignete Fügetechnik z. B. durch Reibschweißen, Löten oder dergleichen mit dem elektrischen Leiter eines Massekabeis verbunden, dessen anderes Ende beispielsweise mit einem Massebolzen der Karosserie verbunden ist. Der Stirnseite 21 gegenüberliegend ist das Widerstandselement des Messwiderstands 20 unmittelbar mit einem Träger 30 verbunden, der seinerseits mit dem Minuspol einer Batterie verbunden werden kann. Zur Verbindung mit dem Träger 30 ist das Widerstandselement in den Träger eingesteckt.

Zur Verbindung des Trägers 30 mit dem Minuspol ist an dem Träger eine Schelle 31 ausgebildet, die über eine Schraube 80 gespannt werden kann. Der Träger 30 weist zur Verbindung mit dem Widerstandselement eine Ring 32 auf, in welchem das der Stirnseite 21 gegenüberliegende Ende des Widerstandelements fest gefügt angeordnet ist. Zwischen dem Ring 32 und dem Widerstandselement ist somit eine belastbare mechanische und elektrische Verbindung hergestellt. Ebenso ist eine mechanisch belastbare elektrische Verbindung zwischen dem nicht dargestellten Massekabel und der Stirnseite 21 des Widerstandelements herstellbar.

Über Kontaktelemente 40 ist das Widerstandselement mit der Schaltungsanordnung zum Auswerten und Bearbeiten von Messgrößen verbunden. Diese Schaltungsanordnung umfasst einen Schaltungsträger 51, auf welcher mehrere nicht dargestellte, elektrische Bauelemente angebracht sind, mit denen die gewünschten physikalischen Größen ermittelt, ausgewertet und bearbeitet werden können. Die Schaltungsanordnung 50 ist über mechanische Verbindungselemente 52 formschlüssig mit dem Widerstandselement des Messwiderstands 20 verbunden. Ein Gehäuse kann die Schaltungsanordnung zum Schutz gegen Feuchtigkeit, mechanischen Belastungen, Hitze, Schmutz oder dergleichen schützen.

Über einen Stecker 60 kann die Schaltungsanordnung mit einem Kabelbaum verbunden werden. Dieser Stecker 60 kann in eine Buchse 70 einer weiterführenden Leitung, die nicht näher dargestellt ist, verbunden werden.

### Bezugszeichenliste

- 1: Batteriesensor
- 20: Messwiderstand
- 21: Stirnseite
- 30: Träger
- 31: Schelle
- 32: Ring
- 40: Kontaktelemente
- 50: Schaltungsanordnung
- 51: Schaltungsträger
- 60: Stecker
- 70: Buchse
- 80: Schraube

## Patentansprüche

1. Sensor (1) unter anderem für ein Kraftfahrzeug, insbesondere Batteriesensor, mit einem Träger (30) und mit einem Messwiderstand (20) umfassend ein Widerstandselement und einer Schaltungsanordnung (50) zum Ermitteln, Auswerten und/oder Bearbeiten von Messgrößen, wobei an dem Träger (30) zur Verbindung mit einem Pol einer Batterie eine Schelle (31) ausgebildet ist, wobei eine Schraube (80) vorgesehen ist, über die die Schelle (31) spannbar ist und wobei der Träger (30) einen Ring (32) aufweist, in welchen ein Ende des Widerstandselementes fest gefügt angeordnet ist,
**dadurch gekennzeichnet,**
**dass** das Widerstandselement unmittelbar an einem Kabel mechanisch und/oder elektrisch angeschlossen ist und
**dass** das Widerstandelement zylindrisch ist und eine Stirnseite hat, die dem mit dem Ring (30) verbundenen Ende gegenüberliegt und unmittelbar mit dem elektrischen Leiter des Kabels verbunden ist.

2. Sensor (1) nach Anspruch 1, **dadurch gekennzeichnet, dass** Messwiderstand (20), insbesondere das Widerstandselement des Messwiderstands (20) einen offenen oder geschlossenen Hohlraum einschließt.

3. Sensor (1) nach Anspruch 2, **dadurch gekennzeichnet, dass** ein Leiter des Kabel in den offenen Hohlraum eingeführt und in dem offenen Hohlraum elektrisch und mechanisch mit dem Widerstandselement verbunden ist.

4. Sensor (1) nach Anspruch 1, 2 oder 3, **dadurch gekennzeichnet, dass** der Leiter des Kabels mit dem Widerstandselement durch Krimpen, Klemmen, Löten, Kleben, Schweißen, insbesondere Orbital- oder Reibschweißen, durch Prägen oder Nieten verbunden ist.

5. Sensor (1) nach einem der Ansprüche 1 bis 4, **dadurch gekennzeichnet, dass** die Schaltungsanordnung (50) zum Ermitteln, Auswerten und/oder Bearbeiten von Messgrößen unmittelbar oder unter Zwischenschaltung von Kontaktelementen (40) mit dem Widerstandselement (20) verbunden ist.

6. Sensor (1) nach Anspruch 5, **dadurch gekennzeichnet, dass** die Kontaktelemente mit dem Widerstandselement (20) oder mit der Schaltungsanordnung (50) bzw. die Schaltungsanordnung (50) mit dem Widerstandselement (20) durch Klemmen, Löten, Kleben, Schweißen, insbesondere Orbital- oder Reibschweißen, durch Prägen oder Nieten verbindbar sind.

7. Sensor (1) nach einem der Ansprüche 1 bis 6, **dadurch gekennzeichnet, dass** die Schaltungsanordnung an dem Träger (30) angebracht ist oder in dem Träger (30) integriert, z. B. eingespritzt oder eingelegt ist.

8. Sensor (1) nach Anspruch 7, **dadurch gekennzeichnet, dass** der Träger (30) eine Buchse (70), einen Stecker, ein Kabel, eine Bluetooth-, Infrarot- oder eine optische Schnittstelle für eine Datenverbindung aufweist.

9. Sensor (1) nach Anspruch 7 oder 8, **dadurch gekennzeichnet, dass** der Träger ein Gehäuse umfasst, in welches die Schaltungsanordnung (50) eingehaust ist.

10. Sensor (1) nach Anspruch 5 oder 6, **dadurch gekennzeichnet, dass** die Kontaktelemente Federn sind.

11. Sensor nach Anspruch 9, **dadurch gekennzeichnet, dass** das Gehäuse durch Urformen erstellt wird.

## Claims

1. A sensor (1), a.o. for a motor vehicle, particularly a battery sensor, having a carrier (30) and a precision resistor (20), comprising a resistor element and a circuit arrangement (50) for the determination, evaluation and / or processing of measured variables, wherein a clip (31) is embodied on the carrier (30) for a connection with a terminal of a battery, wherein a screw (80) is provided, by means of which the clip (31)can be tightened and wherein the carrier (30) has a ring (32) into which one end of the resistor element is joined tightly,
**characterized in that**
the resistor element is directly connected mechanically and/or electrically to a cable, and **in that** the resistor element is cylindrical and has a face being opposite the end connected to the ring (30) and being directly connected to the electrical conductor of the cable.

2. Sensor (1) according to Claim 1, **characterized in that** the precision resistor (20), and particularly the resistor element of the precision resistor (20) encompasses an open or closed hollow space.

3. Sensor (1) according to Claim 2, **characterized in that** a conductor of the cable is inserted into the open hollow space and, in the open hollow space, is electrically and mechanically connected with the resistor element.

4. Sensor (1) according to Claim 1, 2 or 3, **characterized in that** the conductor of the cable is connected to the resistor element by means of crimping, clamping, soldering, gluing, welding, particularly orbital welding or friction welding, by punching or riveting.

5. Sensor (1) according to one of the claims 1 to 4, **characterized in that** the circuit arrangement (50) for the determination, evaluation and/or processing of measured variables is connected directly or by insertion of contact elements (40) to the resistor element (20).

6. Sensor (1) according to claim 5, **characterized in that** the contact elements can be connected with the resistor element (20) or with the circuit arrangement (50) or the circuit arrangement (50) with the resistor element (20) by means of clamping, soldering, gluing, welding, particularly orbital welding or friction welding, by punching or riveting.

7. Sensor (1) according to one of the claims 1 to 6, **characterized in that** the circuit arrangement is attached to the carrier (30) or integrated in the carrier (30), e.g. molded-on or inserted.

8. Sensor (1) according to claim 7, **characterized in that** the carrier (30) has a bush (70), a connector, a cable, a Bluetooth-, infrared- or an optical interface for a data link.

9. Sensor (1) according to claim 7 or 8, **characterized in that** the carrier comprises a housing in which the circuit arrangement (50) is contained.

10. Sensor (1) according to claim 5 or 6, **characterized in that** the contact elements are springs.

11. Sensor according to claim 9, **characterized in that** the housing is generated by means of molding.

## Revendications

1. Capteur (1) entre autres pour un véhicule automobile, surtout un capteur de batterie, avec un support (30) et une résistance de mesure (20) comprenant un élément résistance et un circuit (50) pour déterminer, exploiter et/ou traiter des grandeurs de mesure, un collier (31) étant formé sur le support (30) pour la connexion avec un pôle d'une batterie, une vis (80) étant prévue par laquelle le serrage du collier (31) est assuré et le support (30) présentant une bague (32) dans laquelle un bout de l'élément résistance est disposé solidement fixe,
**caractérisé en ce que**
l'élément résistance est connecté directement à un câble de manière mécanique et/ou électrique et
que l'élément résistance est cylindrique et possède un front qui se trouve en face du bout relié à la bague (30) et qui est directement raccordé au conducteur électrique du câble.

2. Capteur (1) selon la revendication 1, **caractérisé en ce que** la résistance de mesure (20), surtout l'élément résistance de la résistance de mesure (20), comprend une cavité ouverte ou fermée.

3. Capteur (1) selon la revendication 2, **caractérisé en ce qu'**un conducteur du câble est introduit dans la cavité ouverte et est connecté électriquement et mécaniquement à l'élément résistance dans la cavité ouverte.

4. Capteur (1) selon la revendication 1, 2 ou 3, **caractérisé en ce que** le conducteur du câble est connecté à l'élément résistance par sertissage, serrage, brasage, collage, soudage, surtout soudage orbital ou soudage par friction, par matriçage ou rivetage.

5. Capteur (1) selon l'une des revendications 1 à 4, **caractérisé en ce que** le circuit (50) pour déterminer, exploiter et/ou traiter des grandeurs de mesure est directement connecté à l'élément résistance (20) ou par interposition des éléments de contact (40).

6. Capteur (1) selon la revendication 5, **caractérisé en ce que** les éléments de contact sont destinés à être raccordés à l'élément résistance (20) ou au circuit (50) ou bien le circuit (50) à l'élément résistance (20) par serrage, brasage, collage, soudage, surtout soudage orbital ou soudage par friction, par matriçage ou rivetage.

7. Capteur (1) selon l'une des revendications 1 à 6, **caractérisé en ce que** le circuit est monté sur le support (30) ou intégré au support (30), par exemple injecté ou inséré.

8. Capteur (1) selon la revendication 7, **caractérisé en ce que** le support (30) présente un connecteur femelle (70), un connecteur, un câble, une interface Bluetooth, infrarouge ou optique pour un circuit de données.

9. Capteur (1) selon la revendication 7 ou 8, **caractérisé en ce que** le support comprend un boîtier dans lequel le circuit (50) est enrobé.

10. Capteur (1) selon la revendication 5 ou 6, **caractérisé en ce que** les éléments de contact sont des ressorts.

11. Capteur selon la revendication 9, **caractérisé en ce que** le boîtier est réalisé par transformation primaire.
